# EUROPÄISCHE PATENTSCHRIFT

(11) **EP 3 275 296 B1**
(45) Veröffentlichungstag und Bekanntmachung des Hinweises auf die Patenterteilung: **14.10.2020**
(21) Anmeldenummer: 16723640.5
(22) Anmeldetag: 24.03.2016
(51) Int. Cl.: H05K 5/00

(54) **STEUERMODUL MIT EINEM ELEKTROLYTKONDENSATOR SOWIE EINER INTEGRIERTEN ELASTOMERHÜLLE**
CONTROL MODULE COMPRISING AN ELECTROLYTE CAPACITOR AND AN INTEGRATED ELASTOMER SHEATH
MODULE DE COMMANDE DOTÉ D'UN CONDENSATEUR ÉLECTROLYTIQUE ET D'UNE GAINE ÉLASTOMÈRE INTÉGRÉE

(30) Priorität: 27.03.2015 DE 102015205578
(43) Veröffentlichungstag der Anmeldung: 31.01.2018
(73) Patentinhaber: Schaeffler Technologies AG & Co. KG, 91074 Herzogenaurach (DE)
(72) Erfinder: BOTIOV, Julian, 77815 Bühl (DE); ZAEGEL, Didier, 67400 Illkirch (FR)
(86) Internationale Anmeldenummer: PCT/DE2016/200160
(87) Internationale Veröffentlichungsnummer: WO 2016/155736

(56) Entgegenhaltungen:
- EP-A2- 2 107 864
- DE-A1-102005 059 584
- DE-A1-102013 215 949

## Beschreibung

Die Erfindung betrifft ein Elektronikmodul (auch als Steuermodul bezeichnet) für einen in einem Kraftfahrzeug, wie einen Pkw, Lkw, Bus oder landwirtschaftlichen Nutzfahrzeug, verwendeten Aktor, mit einem Gehäuse und einer in dem Gehäuse aufgenommenen Leiterplatte. Auch betrifft die Erfindung einen Aktor zum Betätigen einer Kupplung und/oder eines Getriebes eines Kraftfahrzeuges (d.h. einen Kupplungs- und/oder Getriebeaktor), mit einem solchen Elektronikmodul, das dann elektrisch mit einer Antriebseinheit (umfassend einen Elektromotor) des Aktors verbunden ist.

Prinzipiell sind Elektronikmodule zur Erfassung von Betriebsdaten einer Antriebseinheit eines Aktors und / oder zur Steuerung der Antriebseinheit bereits bekannt. Die WO 2011/050767 A1 offenbart einen Hydrostataktor mit einem Geberzylinder enthaltend ein Gehäuse und einen in dem Gehäuse axial verlagerbaren, eine mit Druckmittel befüllte Druckkammer mit Druck beaufschlagenden Kolben, mit einem einen Drehantrieb in eine Axialbewegung wandelnden Planetenwälzgetriebe, mit einer Hülse, einer Getriebespindel und zwischen diesen abwälzenden Planetenwälzkörpern sowie mit einem das Planetenwälzgetriebe antreibenden Elektromotor mit einem gehäusefest verbundenen Stator und einem gegenüber diesem verdrehbaren Rotor, wobei die Druckkammer ringförmig ausgebildet ist und das Planetenwälzgetriebe radial innerhalb der Druckkammer angeordnet ist. Auf einer Platine einer Vorortelektronik ist dabei zumindest ein Sensor zur Erfassung von Betriebsdaten des Hydrostataktors angeordnet.

Die DE 10 2013 215 949 A1 offenbart einen Elektromotor, vorzugsweise ein elektrisch kommutierter Motor, umfassend ein Gehäuse, in welchem ein Elektronikmodul, bestehend aus einer Elektronikeinheit und einer Wärmesenke, angeordnet ist, wobei das Gehäuse von der Wärmesenke abgeschlossen ist und die an einem Stator abgegriffenen elektrischen Motorphasen mit einer Steckereinheit verbunden sind. Die mechanischen Verbindungen der Elektronikeinheit mit der Wärmesenke und / oder dem Gehäuse und / oder die elektrischen Verbindungen der elektrischen Motorphasen des Stators und der Elektronikeinheit mit der Steckereinheit sind schraubverbindungsfrei ausgeführt.

Insbesondere bei der Verwendung von relativ massiven elektrischen Bauteilen, wie z.B. von Elektrolytkondensatoren, die zu den massivsten Bauteilen bei einem Verbau in einem Elektronikmodul zählen, hat es sich herausgestellt, dass diese Bauteile im Betrieb des Aktors zum Schwingen, in bestimmten Fahrzuständen des Kraftfahrzeuges, angeregt werden können. Es hat sich hierbei weiterhin herausgestellt, dass sich die relativ massiven Bauteile / Elektrolytkondensatoren, vor allem bei auftretenden Vibrationen / Schwingungen, d.h. bei periodisch wiederkehrenden Bewegungen, derart stark bewegen können, dass gar Beschädigungen in dem Elektronikmodul bzw. des Bauteils verursacht werden können. Wenn sich ein massiver Kondensators stark relativ zu dem Gehäuse bewegt / aufschwingt, können hierbei insbesondere Beschädigungen des internen Aufbaus dieses Kondensators vorkommen; es können jedoch auch eventuelle Schweißstellen in dem Gehäuse und/oder in dem Bauteil beschädigt werden. Auch die Lötstellen zwischen dem Bauteil / Kondensator und der Leiterplatte (auch als PCB ("Printed Circuit Board") / gedruckte Schaltung bezeichnet) können beschädigt werden. Kondensator-Leiterplatten-Verbindung eine kritische Stelle bzgl. der Vibrationsrobustheit des Elektronikmoduls bildet.

Aus der EP 2 107 864 A2 ist ein wärmeleitender Kleber zwischen einem elektronischen Bauteil und einer Aufnahme für das Bauteil bekannt. Dieser Kleber weist eine Elastizität auf, welche aber geringer als die Elastizität der der Anbindung der elektronischen Bauteile sein soll.

Aus der DE 10 2005 059 584 A1 ist ein Bauelement bekannt, welches über ein mechanisches Dämpfungselement mit der Leiterplatte verbunden ist. Das Bauelement ist dabei über eine Klammer mit der Leiterplatte verbunden. An der Innenseite der Klammer können dämpfende Streifen oder eine Schicht aus einem Elastomer vorgesehen sein.

Es ist somit die Aufgabe der vorliegenden Erfindung, den Einsatz von Elektronikmodulen in einem Kraftfahrzeug weiter zu verbessern, wobei insbesondere innere Beschädigungen des Elektronikmoduls möglichst vermieden werden sollen.

Dies wird erfindungsgemäß bei einer gattungsgemäßen Vorrichtung durch die kennzeichnenden Merkmale des Anspruchs 1 gelöst. Ausgestaltungsformen sind in den Unteransprüchen beschrieben.

Ein elektronisches Bauteil, das mit der Leiterplatte (vorzugsweise elektrisch) verbunden ist und in einem (vorzugsweise domartigen) Aufnahmeabschnitt des Gehäuses angeordnet ist, zumindest abschnittsweise von außen von einer Dämpfungshülle umgeben ist, welche Dämpfungshülle dämpfend auf eine Relativbewegung zwischen dem elektronischen Bauteil und dem Aufnahmeabschnitt einwirkt.

Die Anordnung einer solchen Dämpfungshülle bewirkt eine deutliche Schwingungsreduktion des elektronischen Bauteils relativ zu dem Gehäuse / dem Aufnahmeabschnitt. Dadurch ist eine besonders dauerhafte und robuste Anbindung des elektronischen Bauteils an der Leiterplatte umgesetzt.

Von Vorteil ist es, wenn die Dämpfungshülle aus einem Elastomermaterial / Elastomer (d.h. einem elastomeren Kunststoff) hergestellt ist / besteht, wodurch die Dämpfungshülle besonders kostengünstig ausgestaltbar ist.

Besonders effektiv wirkt die Dämpfungshülle, wenn das elektronische Bauteil ein Kondensator, besonders ein Elektrolytkondensator, ist. Denn Kondensatoren, besonders die Elektrolytkondensatoren sind relativ massive Bauteile, die in den realen Applikationen in Automotive-Elektronikmodulen oft zu einer Bewegung relativ zu dem Gehäuse angeregt werden.

In diesem Zusammenhang wirkt die Dämpfungshülle auch besonders effektiv, wenn der Kondensator auf der Leiterplatte befestigt, etwa angelötet / angeschweißt ist, da eine solche gegenüber Schwingungen besonders anfällige Verbindung dann verlässlich abgestützt / unterstützt ist.

Vorteilhaft ist es auch, wenn die Dämpfungshülle (zumindest jeweils abschnittsweise) an dem elektronischen Bauteil / Elektrolytkondensator und dem Aufnahmeabschnitt anliegt. Dadurch ist eine besonders einfache Abstützung umgesetzt, wodurch auch der Bauraum zwischen dem elektronischen Bauteil und dem Aufnahmeabschnitt besonders effizient ausgenutzt ist.

Die Dämpfungshülle ist erfindungsgemäß hülsenförmig ausgestaltet und weist mehrere voneinander beabstandete, (vorzugsweise in einer radialen Richtung des Elektrolytkondensators) abstehende Erhebungen auf, die vorzugsweise an dem Aufnahmeabschnitt anliegen, ist eine noch effektivere Dämpfung umgesetzt, da die Abstützstellen gleichmäßig auf die äußere Mantelfläche des Bauelements, bzw. an der Abstützungsfläche des Elektronikgehäuses verteilt sind.

In diesem Zusammenhang ist es auch vorteilhaft, wenn die Erhebungen (im montierten Zustand des Elektronikmoduls) derart komprimiert gehalten sind, dass die Dämpfungshülle in einem die Erhebungen geometrisch voneinander abgrenzenden Talbereich / Verbindungsbereich, unter Ausbildung eines (vorzugsweise zur Umgebung hin offenen) Entlüftungsspaltes, beabstandet zu dem Aufnahmeabschnitt angeordnet ist. Dadurch wird vermieden, wenn die Dämpfungshülle, vorzugsweise samt elektronischen Bauteil sowie Leiterplatte, in den Aufnahmeabschnitt eingesetzt wird, dass unbeabsichtigte Luftpolster, bzw. Luftdruckerhöhung ausgebildet werden. Dadurch ist eine gleichmäßige Anlage der Dämpfungshülle an dem Aufnahmeabschnitt gewährleistet.

Zudem ist es zweckmäßig, wenn die Dämpfungshülle einen (sich vorzugsweise in axialer Richtung des elektronischen Bauteils erstreckenden) Schlitz aufweist, der sich weiter bevorzugt von einem (zweiten) Endbereich der Dämpfungshülle weg erstreckt. Denn dadurch kann die Dämpfungshülle im Bereich des Schlitzes besonders kraftlos aufgeweitet werden, um sie bei der Montage auf das elektronische Bauteil aufzuschieben.

Zweckmäßig ist es zudem, wenn die Dämpfungshülle an einer radialen Innenseite, mit der sie an dem elektronischen Bauteil anliegt, zumindest eine Aushöhlung aufweist, die komplementär zu einer Erhabenheit des elektronischen Bauteils ausgestaltet ist. Dadurch ist die Dämpfungshülle besonders eng um das elektronische Bauteil herum anliegend und der Bauraum für die Dämpfungshülle wird weiter reduziert.

Bildet die Dämpfungshülle weiterhin an einem (ersten) Endbereich einen (sich vorzugsweise in radialer Richtung des elektronischen Bauteils erstreckenden) Bodenabschnitt aus, der ein zentrales, durchgängiges Entlüftungsloch aufweist, kann die Dämpfungshülle bei deren Montage noch einfacher auf das elektronische Bauteil aufgeschoben werden, ohne dass sich in einem Zwischenraum zwischen dem elektronischen Bauteil und der Dämpfungshülle unbeabsichtigt ein Luftpolster, bzw. eine Luftdruckerhöhung ausbildet. Eine möglichst gleichmäßige Anlage der Dämpfungshülle an dem elektronischen Bauteil ist die Folge.

Ist die Dämpfungshülle weiterhin an dem, diesem (ersten) den Bodenabschnitt aufweisenden Endbereich gegenüberliegenden, (zweiten) Endbereich in Form einer Einschiebeöffnung ausgebildet, in die das elektronische Bauteil im montierten Zustand derart eingeschoben ist, dass es mit seiner Außenseite an der Innenumfangsseite der Dämpfungshülle anliegt, ist die Dämpfungshülle besonders einfach auf das elektronische Bauteil aufschiebbar / aufstülpbar.

Zweckmäßigerweise weist die Dämpfungshülle auch zumindest zwei Teilabschnitte auf bzw. bildet diese aus, wovon ein erster Teilabschnitt einen größeren Innendurchmesser aufweist als ein zweiter Teilabschnitt. Dadurch kann die Dämpfungshülle noch besser an die jeweilige Geometrie verschiedenartig ausgestalteter elektronischer Bauteile angepasst werden.

Ist das elektronische Bauteil weiterhin an der Leiterplatte angelötet, ist im Betrieb eine besonders gegenüber Vibrationsbelastungen robuste Verbindung zwischen dem elektronischen Bauteil und der Leiterplatte umgesetzt.

Weiterhin umfasst die Erfindung auch den Aktor zum Betätigen einer Kupplung und / oder eines Getriebes eines Kraftfahrzeuges selbst, mit einem Elektronikmodul nach zumindest einer der zuvor beschriebenen Ausführungsformen, welches Elektronikmodul elektrisch mit einer Antriebseinheit des Aktors verbunden ist. Dadurch ist auch der Aktor besonders leistungsfähig.

Vorzugsweise ist der Aktor ein hydrostatischer Aktor / Hydrostataktor. Weiter bevorzugt ist das Elektronikmodul nach der Art eines Steuermoduls mit einem Elektromotor der Antriebseinheit des Aktors elektrisch verbunden. Die Leiterplatte umfasst dabei mindestens einen Rotorlagesensor, der zum Ermitteln einer Drehstellung eines Rotors des Elektromotors ausgebildet / vorbereitet ist.

Der Aktor ist weiter bevorzugt als ein hydraulischer oder mechanischer Kupplungsaktor ausgebildet. Weiterhin kann die hier beschriebene vibrationsrobuste Integrationsart von Elektrolytenkondensatoren auf andere Antriebsmodule für Aktorik in KfZ- Bereich angewandt werden.

Die Erfindung betrifft somit, in anderen Worten ausgedrückt, einen genoppten Elastomerüberzieher (eine Dämpfungshülle) für elektronische Bauteile, bevorzugt Elektrolytkondensatoren, wobei der Elastomerüberzieher sowie der Elektrolytkondensator Teil eines Steuermoduls (Elektronikmodul) sind, um eine Robustheitserhöhung von Vibrationsbelastungen umzusetzen. Das Steuermodul ist insbesondere für einen Aktor, vorzugsweise einen Getriebe- und / oder Kupplungsaktor in einem Kraftfahrzeug vorgesehen. Das Elektronikmodul umfasst eine Leiterplatte mit einem Elektrolytkondensator in einem Dom (Aufnahmeabschnitt), bzw. einem Gehäuse / Kunststoffgehäuse. Der Elektrolytkondensator ist erfindungsgemäß von einer Dämpfungshülle (auch als Elastomerhülle bezeichnet) umgeben. Diese weist bevorzugt Noppen (Erhebungen) und dazwischen liegende Täler (Talbereich) auf. Auf diese Weise werden nur die Noppen lokal von dem Gehäuse zusammengepresst und verringern die Belastung auf die Lötstellen, wobei weiter eine Belüftung möglich ist. Ziel ist es, durch die Integration der Elastomerhülle als Dämpfungselement die Robustheit bei Vibrationen von einem im Steuermodul integrierten Elektrolytkondensator somit zu erhöhen.

Die Erfindung wird nun nachfolgend anhand von Figuren näher erläutert, in welchem Zusammenhang auch verschiedene Ausführungsformen beschrieben sind.

Es zeigen:
- Fig. 1: eine isometrische Darstellung eines erfindungsgemäßen Elektronikmoduls nach einer vorteilhaften Ausführungsform, wobei das Elektronikmodul im Bereich des Aufnahmeabschnittes, der das als Elektrolytkondensator ausgeführte elektronische Bauteil umhüllt, geschnitten dargestellt ist und die Anordnung des Elektrolytkondensators relativ zur Leiterplatte zu erkennen ist,
- Fig. 2: eine Längsschnittansicht des Elektronikmoduls nach Fig. 1, wobei wiederum das Gehäuse sowie die Leiterplatte im Bereich des Elektrolytkondensators geschnitten dargestellt sind und besonders gut der Zwischenraum zwischen dem Aufnahmeabschnitt und dem Elektrolytkondensator, in dem die erfindungsgemäße Dämpfungshülle angeordnet ist, ersichtlich ist,
- Fig. 3: eine isometrische Darstellung eines Teilzusammenbaus aus Leiterplatte, Elektrolytkondensator und der auf dem Elektrolytkondensator aufgeschobenen Dämpfungshülle, wobei besonders gut die Außenumfangsseite der Dämpfungshülle mit ihren Erhebungen erkennbar ist,
- Fig. 4: eine isometrische Darstellung des Elektrolytkondensators, wie er in dem Elektronikmodul nach den Fign. 1 und 2 und dem Teilzusammenbau aus Fig. 3 eingesetzt ist, wobei die Dämpfungshülle, wie mit dem Pfeil ersichtlich, kurz vor dem Aufschieben auf den Elektrolytkondensator, jedoch noch getrennt vom Elektrolytkondensator, dargestellt ist,
- Fig. 5a: eine isometrische Darstellung der Dämpfungshülle der ersten Ausführungsform, wie sie in den Fign. 1 bis 4 dargestellt ist,
- Fig. 5b: eine in Längsrichtung geschnitten dargestellte Dämpfungshülle nach Fig. 5a, wobei besonders gut zum einen ein in der Dämpfungshülle eingebrachter Schlitz sowie das Entlüftungsloch in einem Bodenabschnitt der Dämpfungshülle erkennbar sind,
- Fig. 6a: eine isometrische Darstellung einer Dämpfungshülle nach einer weiteren vorteilhaften Ausführungsform, wobei die Dämpfungshülle nach Fig. 6a gegenüber der Dämpfungshülle nach den Fign. 5a und 5b mehrere Verdickungsbereiche aufweist, die sich bis zu dem Bodenabschnitt hin erstrecken,
- Fig. 6b: eine isometrische Darstellung der Dämpfungshülle nach Fig. 6a, die nun in Längsrichtung geschnitten ist, sowie
- Fig. 7: eine isometrische Darstellung einer Dämpfungshülle nach einer weiteren vorteilhaften Ausführungsform, wobei in dieser Ausführung gegenüber der Ausführungsform nach den Fign. 6a und 6b die Anzahl an Erhebungen reduziert ist.

Die Figuren sind lediglich schematischer Natur und dienen ausschließlich dem Verständnis der Erfindung. Die gleichen Elemente sind mit denselben Bezugszeichen versehen. Auch können die verschiedenen Merkmale der unterschiedlichen Ausführungsformen frei miteinander kombiniert werden.

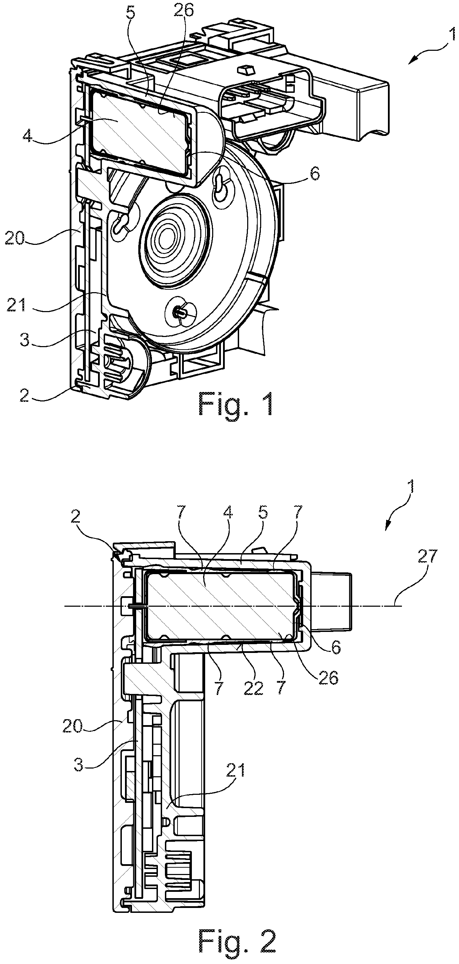

In Fig. 1 ist zunächst ein Elektronikmodul 1 der erfindungsgemäßen Art gemäß eines ersten Ausführungsbeispiels / einer ersten Ausführungsform besonders anschaulich dargestellt. Das Elektronikmodul 1 dient hierbei zum Einsatz in einem Aktor, der als Getriebe- und Kupplungsaktor ausgestaltet ist und daher zum Betätigen einer Kupplung und eines Getriebes eines Kraftfahrzeuges dient. Alternativ dient dieses Elektronikmodul 1 als Bauteil in einem Aktor, der als Getriebeaktor oder als Kupplungsaktor ausgestaltet ist. Der Aktor ist in Form eines Hydrostataktors ausgebildet, der wiederum wie der in der WO 2011/050767 beschriebene Hydrostataktor aufgebaut ist und funktioniert. Das Elektronikmodul 1 dient zum Erfassung von Betriebsdaten einer Antriebseinheit des Aktors und zur Steuerung der Antriebseinheit. Dabei ist das Elektronikmodul 1 bei dem Einsatz in einem solchen Aktor elektrisch mit der Antriebseinheit, die einen Elektromotor umfasst, des Aktors verbunden. Dadurch kann die Antriebseinheit, die wiederum die Stellung zumindest eines Stellgliedes der Kupplung oder des Getriebes beeinflusst, durch das Elektronikmodul 1 gesteuert werden.

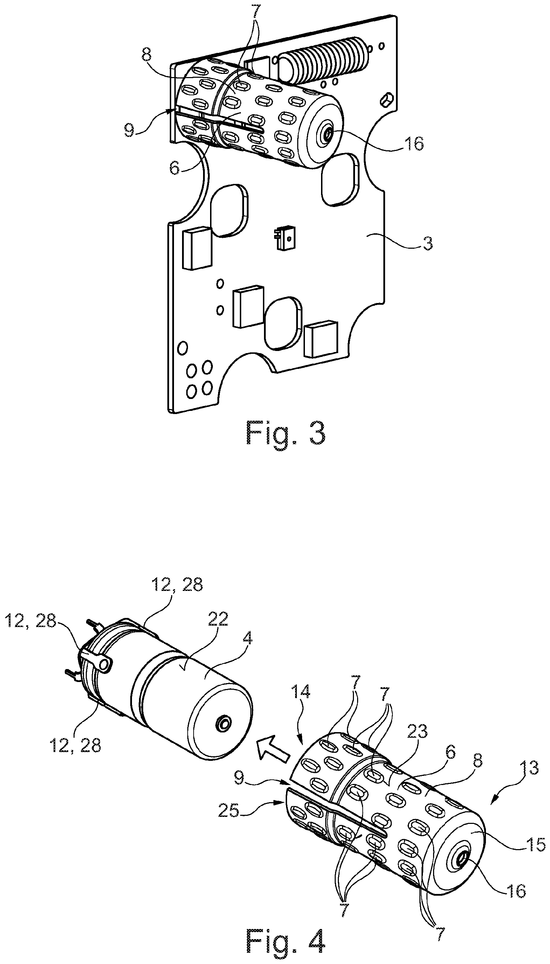

Das Elektronikmodul 1 weist ein Gehäuse 2 auf. Das Gehäuse 2 ist in dieser Ausführung mehrteilig ausgebildet. Einerseits weist das Gehäuse 2 einen Deckel 20, andererseits einen Aufnahmekörper 21 auf, in dem sowohl eine Leiterplatte 3, die auch als Platine bezeichnet ist, als auch ein als Elektrolytkondensator ausgebildetes elektronisches Bauteil 4 aufgenommen sind. Das elektronische Bauteil 4 ist demzufolge nachfolgend auch als Elektrolytkondensator 4 bezeichnet. Im Bereich des Elektrolytkondensators 4 ist dieser Aufnahmekörper 21 / das Gehäuse 2 mit einem hohlen, im Wesentlichen topfförmigen Aufnahmeabschnitt 5 ausgebildet. Der sich im Wesentlichen zapfenförmig erstreckende Elektrolytkondensator 4 ist somit in diesem Aufnahmeabschnitt 5 im montierten Zustand eingeschoben, d.h. der Aufnahmeabschnitt 5 nimmt in seinem Innenraum den Elektrolytkondensator 4 auf und umschließt / umgibt ihn von außen. Wie auch besonders gut in Fig. 3 zu erkennen, ist die Leiterplatte 3 derart ausgebildet, dass sie sich im Wesentlichen in einer Plattenebene erstreckt. Senkrecht zu dieser Plattenebene ist der Elektrolytkondensator 4 in seiner Längsrichtung verlaufend aufgesetzt / aufgeschoben / befestigt. Der Elektrolytkondensator 4 erstreckt sich somit mit seiner Längsachse 27 im Wesentlichen senkrecht zu der Erstreckungsebene der Leiterplatte 3.

Der Elektrolytkondensator 4 ist im montierten Zustand, wie er in Fig. 3, jedoch auch in den Fign. 1 und 2 zu erkennen ist, auf der Leiterplatte 3 aufgelötet und durch den Aufnahmeabschnitt 5 radial von außen (in Bezug auf die Längsachse 27) umschlossen. Der Elektrolytkondensator 4 ist weiterhin elektrisch mit der Leiterplatte 3, d.h. mit auf der Leiterplatte 3 angebrachten elektrischen Verbindungsleitungen verbunden. Benachbart zu dem Aufnahmeabschnitt 5 ist der Aufnahmekörper 21 wiederum im Wesentlichen plattenförmig / tellerartig ausgebildet und erstreckt sich dabei im Wesentlichen parallel zu der Erstreckungsebene der Leiterplatte 3.

Erfindungsgemäß ist zwischen dem Elektrolytkondensator 4 und dem Aufnahmeabschnitt 5 eine Dämpfungshülle 6 aufgebracht. Da die Dämpfungshülle 6 in dieser Ausführung aus einem elastomeren Kunststoff besteht, ist sie nachfolgend auch als Elastomerhülle 6 bezeichnet. Die Elastomerhülle 6 ist dabei besonders gut im auf den Elektrolytkondensator 4 aufgeschobenen Zustand in Fig. 3 zu erkennen. Die Elastomerhülle 6 dient hierbei als Dämpfungselement zur Dämpfung von periodisch auftretenden Relativbewegungen / Schwingungen zwischen dem Elektrolytkondensator 4 und dem Aufnahmeabschnitt 5 / dem Gehäuse 2 im Betrieb des Aktors, etwa im Betrieb eines Kraftfahrzeuges. Zu diesem Zwecke umgibt die Elastomerhülle 6 den Elektrolytkondensator 4 derart von außen, dass sie den Elektrolytkondensator 4 an seiner Außenseite 22, nämlich seiner radialen Außenseite umhüllt / umgibt.

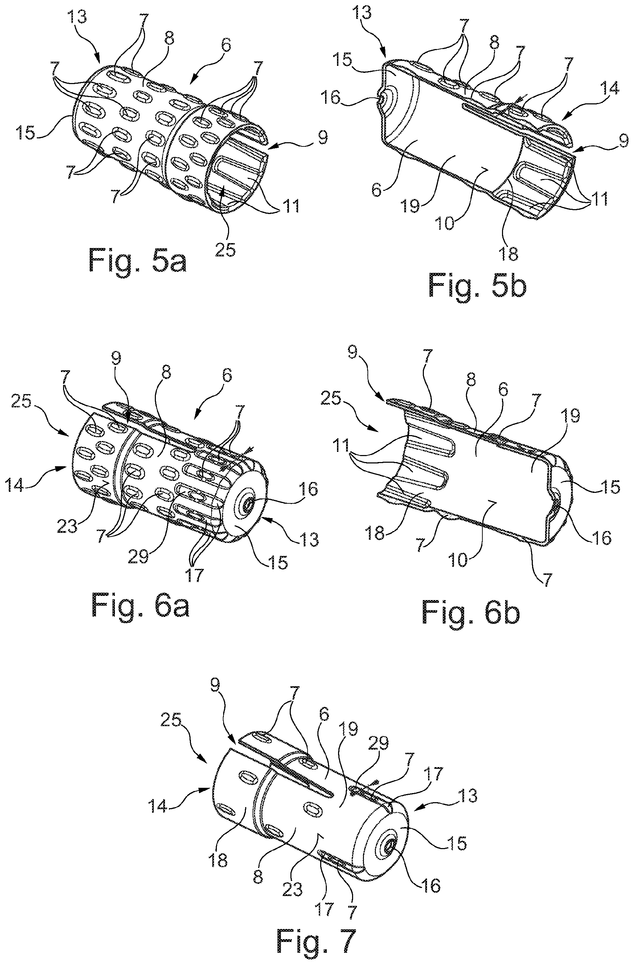

Wie in den Fign. 5a und 5b besonders gut zu erkennen ist, ist die Elastomerhülle 6 in ihrer Längsrichtung betrachtet im Wesentlichen in zwei hülsenförmige / hülsenartige Teilabschnitte 18 und 19 unterteilt, welche Teilabschnitte 18, 19 den Elektrolytkondensator 4 radial von außen umgeben / umhüllen. Ein erster Teilabschnitt 18 ist gegenüber einem zweiten Teilabschnitt 19, der in axialer Richtung der Elastomerhülle 6 an den ersten Teilabschnitt 18 anschließt, nach außen hin, d.h. in radialer Richtung nach außen abgesetzt. Die axiale und radiale Richtung in Bezug auf die Elastomerhülle 6 entspricht aufgrund der koaxialen Anordnung zwischen Elastomerhülle 6 und Elektrolytkondensator 4 im montierten Zustand der axialen und radialen Richtung in Bezug auf die Längsachse 27.

Der erste Teilabschnitt 18 weist einen größeren Innendurchmesser auf als der zweite Teilabschnitt 19. Der erste Teilabschnitt 18 weist auch einen größeren Außendurchmesser auf als der zweite Teilabschnitt 19. Die radiale Innenumfangsseite 10, die auch als Innenseite schlicht bezeichnet ist, des ersten und des zweiten Teilabschnittes 18, 19 / der Elastomerhülle 6, liegt unmittelbar an einer radialen Außenseite 22 des Elektrolytkondensators 4 an.

An einem dem ersten Teilabschnitt 18 in axialer Richtung abgewandten Seite / Ende geht der zweite Teilabschnitt 19 in einen weiteren, als Bodenabschnitt 15 bezeichneten dritten Teilabschnitt der Elastomerhülle 6 über. Der Bodenabschnitt 15 bildet mit den anderen beiden Teilabschnitten 18 und 19 die Elastomerhülle 6 topfförmig aus. Der Bodenabschnitt 15 ist somit an einem ersten Endbereich 13 der Elastomerhülle 6 angeordnet. Einen zweiten Endbereich 14 der Elastomerhülle 6, der dem ersten Endbereich 13 abgewandt ist, bildet wiederum das axiale Ende des ersten Teilabschnittes 18 aus. Dieser zweite Endbereich 14 weist eine Einschiebeöffnung 25 auf, die auf den Elektrolytkondensator 4 derart abgestimmt ist, dass die Elastomerhülle 6 gemäß Fig. 4 von einer Stirnseite des Elektrolytkondensators 4 her auf diesen Elektrolytkondensator 4 axial aufschiebbar ist (Pfeil).

Um das Aufschieben der Elastomerhülle 6 auf den Elektrolytkondensator 4 weiterhin zu erleichtern, ist die Elastomerhülle 6 von ihrem zweiten Endbereich 14 aus geschlitzt ausgebildet. Die Elastomerhülle 6 weist daher, wie sie in Fign. 5a und 5b zu erkennen ist, einen sich in axialer Richtung der Elastomerhülle 6 erstreckenden Schlitz 9 auf. Der Schlitz 9 ist von dem zweiten Endbereich 13 aus in axialer Richtung in die Elastomerhülle 6 eingebracht und durchdringt den ersten Teilabschnitt 18 vollständig sowie den zweiten Teilabschnitt 19 zumindest teilweise in radialer Richtung. Dadurch kann mit besonders wenig Kraftaufwand die Elastomerhülle 6 auf den Elektrolytkondensator 4 aufgeschoben werden.

Wie weiterhin in den Fign. 1 und 2 auch zu erkennen ist, liegt die Elastomerhülle 6 auch an dem Aufnahmeabschnitt 5 an. Zu diesem Zwecke weist die Elastomerhülle 6 mehrere sich in radialer Richtung erstreckende Erhebungen 7 an ihrer radialen Außenumfangsseite 23 auf, die auch als Noppen bezeichnet sind. Diese somit noppenförmigen Erhebungen 7 sind sowohl in axialer Richtung als auch entlang mehrerer gedachter Umfangslinie innerhalb verschiedener Radialebene der Elastomerhülle 6 verteilt angeordnet.

Durch die Erhebungen 7 kommt es im montierten Zustand gemäß Fig. 1 und 2 im Gehäuse 2 nicht zu einer vollständigen, d.h. komplettflächigen Anlage der Außenumfangsseite 23 der Elastomerhülle 6 an der Innenmantelseite 26 / Innenseite des Aufnahmeabschnittes 5, sondern im Wesentlichen zu einer punktförmigen Anlage jeweils im Bereich der Erhebungen 7. Somit liegt die Elastomerhülle 6 vereinzelt, nämlich nur im Bereich der Erhebungen 7 an dem Aufnahmeabschnitt 5 mit ihrer Außenumfangsseite 23 an.

Die Elastomerhülle 6 ist dabei derart in dem Aufnahmeabschnitt 5 eingepresst / eingeschoben / eingedrückt, dass die Erhebungen 7 unter Vorspannung in radialer Richtung zusammengedrückt / komprimiert sind. Dadurch ist eine besonders effiziente Dämpfung von Schwingungen im Betrieb umgesetzt. Wie bspw. in Fig. 2 auch besonders gut zu erkennen, erstreckt sich der Aufnahmeabschnitt 5 in axialer Richtung nicht ideal zylindrisch, sondern konisch und verengt sich in axialer Richtung von der Leiterplatte 3 weg. Zu diesem Zwecke ist es besonders sinnvoll, die beiden Teilabschnitte 18 und 19 vorzusehen, da somit Erhebungen 7 im Wesentlichen auf zwei unterschiedlichen Umfangslinien um die Längsachse 27 des Elektrolytkondensators 4, die der Längsachse der Elastomerhülle 6 entspricht, ausgebildet sind.

Die einzelnen Erhebungen 7 sind geometrisch betrachtet voneinander beabstandet, d.h. sie gehen geometrisch nicht ineinander über. Zwischen jedem der Erhebungen 7 ist somit zu den jeweils benachbarten Erhebungen 7 ein so genannter Verbindungsbereich 8 (im Sinne eines Tals / Talbereiches) ausgebildet, der im montierten Zustand des Elektronikmoduls 1 beabstandet, nämlich in radialer Richtung beabstandet zu der Innenmantelseite 26 des Aufnahmeabschnittes 5 angeordnet ist. Dadurch ergibt sich zwischen dem Aufnahmeabschnitt 5 und dem Verbindungsbereich 8 ein im montierten Zustand ausgebildeter, zusammenhängender Entlüftungsspalt, der zur Umgebung der Elastomerhülle 6 hin geöffnet ist. Beim Einschieben der Leiterplatte 3 / des Zusammenbaus der Leiterplatte 3, des Elektrolytkondensators 4 sowie der Elastomerhülle 6 (Fig. 3) in das Gehäuse 2 bzw. in den Aufnahmekörper 21, wird daher die Bildung eines Luftpolsters, bzw. Luftdruckerhöhung zwischen der Elastomerhülle 6 und dem Aufnahmeabschnitt 5 vermieden.

Zudem ist in dem Bodenabschnitt 15 der Elastomerhülle 6 ein Entlüftungsloch 16 zentral angeordnet, weshalb auch beim Aufschieben der Elastomerhülle 6 auf den Elektrolytkondensator 4 Luft entweichen kann. Auch dadurch wird eine so genannte Luftpolstereinschließung / Luftdruckerhöhung vermieden.

Weiterhin umfasst die Elastomerhülle 6 auch mehrere an ihrer Innenumfangsseite 24 verteilt angeordnete Aushöhlungen 11. Auch diese Aushöhlungen 11 sind entlang einer gedachten Umfangslinie um die Längsachse 27 herum verlaufend verteilt angeordnet. Jeder der Aushöhlungen 11 ist dabei auf eine, wie in Fig. 4 besonders gut zu erkennende Erhabenheit 12, bspw. eine Halteklammer 28 des Elektrolytkondensators 4, abgestimmt. Die Erhabenheiten 12 sind dadurch, ohne die Elastomerhülle 6 zu zerstören, ebenfalls in die Elastomerhülle 6 einschiebbar. Die Aushöhlungen 11 sind hierbei in axialer Richtung betrachtet im ersten Teilabschnitt 18 vorgesehen.

Die Außenseite 22 des Elektrolytkondensators 4 ist in dieser Ausführung Teil eines aus Aluminium hergestellten Kondensatorabschnittes. Das Gehäuse 2 ist aus Kunststoff hergestellt, d.h. der Aufnahmekörper 21 ist aus einem Kunststoffmaterial bestehend. Der Deckel 20 kann je nach Wärmemanagementsituation aus Aluminium, oder aus Kunststoff hergestellt sein / bestehen (In diesem praktischen Applikationsfall ist der Deckel 20 aus Aluminium bestehend). Die Elastomerhülle 6 ist aus einem geeigneten schwingungsdämpfenden, elastomeren Kunststoffmaterial hergestellt / bestehend. Die Elastomerhülle 6 ist spritzgußtechnisch hergestellt. Die Form / Ausformung der Elastomerhülle 6 mit den in Umfangrichtung ausgeprägten Erhebungen 7 kann sehr gut in so einem (Spritzguß-)Verfahren zwangsentformt werden.

In den Fign. 6a und 6b ist eine weitere vorteilhafte Ausführungsform der Elastomerhülle 6 dargestellt, welche Elastomerhülle 6 in einer weiteren Ausführungsform in dem erfindungsgemäßen Elektronikmodul 1 nach den Fign. 1 und 2 eingesetzt ist. Die Elastomerhülle 6 gemäß diesen Fign. 6a und 6b ist im Wesentlichen wie die Elastomerhülle 6 der Fign. 5a und 5b ausgestaltet sowie aufgebaut. Als wesentlicher Unterschied sind hierbei verschiedene Verdickungsbereiche 17 an der Elastomerhülle 6 angeordnet. Jeder Verdickungsbereich 17 ist zusammen mit einer Erhebung 7 am zweiten Teilabschnitt 19 ausgeformt. Die Verdickungsbereiche 17 erstrecken sich jedoch in axialer Richtung der Elastomerhülle 6 weiter als die Erhebungen 7. Auch erstrecken sich die Verdickungsbereiche 17 bis zu dem Bodenabschnitt 15 in axialer Richtung hin. Die Verdickungsbereiche 17 sind wiederum voneinander sowie von den jeweils benachbarten Erhebungen 7 beabstandet. Die auf jeden Verdickungsbereich 17 aufgebrachte Erhebung 7 erstreckt sich wiederum in radialer Richtung etwas weiter nach außen als ein Grundsockelabschnitt 28 des jeweiligen Verdickungsbereiches 17.

Eine weitere vorteilhafte Ausführungsform bzgl. der Elastomerhülle 6 ist in Fig. 7 dargestellt, welche Elastomerhülle 6 in einer weiteren Ausführungsform in dem erfindungsgemäßen Elektronikmodul 1 nach den Fign. 1 und 2 eingesetzt ist und wobei nun gegenüber der Fign. 6a und 6b die Anzahl an Erhebungen 7 reduziert ist. Dadurch ist verdeutlicht, dass die Anzahl an Erhebungen 7 nicht auf die in den Fign. 5a bis 6b dargestellten Anzahlen festgelegt ist, sondern auch weniger oder mehr Erhebungen 7 an der Elastomerhülle 6 ausgestaltet sein können. Auch die Verdickungsbereiche 17 können dabei in der Anzahl unterschiedlich ausgestaltet sein. Dadurch kann man je nach Montageanforderungen und Design-Richtlinien von den Bauteilen entsprechend eine Variierung der Montagekräfte realisieren.

In anderen Worten ausgedrückt, ist somit ein Elektrolytkondensator 4 (auch als "Elko" abgekürzt) auf die PCB (Leiterplatte 3) des Elektronikmoduls 1 eingelötet / aufgelötet, wobei die PCB 3 in einem Kunststoffgehäuse (Gehäuse 2) montiert ist. Insbesondere der Aufnahmekörper 21 ist dabei aus Kunststoff hergestellt. Dabei wird der Elko 4 in einem Dombereich (Aufnahmeabschnitt 5) in dem Kunststoffgehäuse 2 des Elektronikmoduls 1 eingeführt. Die Elastomerhülle 6 ist auf dem Elko 4 montiert und wird somit radial zwischen der Außenwandung (Außenseite 22) des Elko's 4 und der konischen Innenfläche (Innenmantelseite 26) des Kunststoffgehäuses 2 zusammengepresst. Insbesondere wird sie dabei in den Bereichen der Noppenerhöhungen (Erhebungen 7) zusammengepresst. Somit wird der Elko 4 gleichzeitig einerseits sehr stabil gehalten und andererseits durch den Dämpfungseffekt des Elastomermaterials der Elastomerhülle 6 in einem gewissen Anteil mechanisch entkoppelt von den Vibrationen der Kunststoffwandung (des Gehäuses 2). Die Dämpfungsfunktion der Elastomerhülle 6 auf den Elko 4 kann durch eine geeignete Materialauswahl variiert werden, wobei unterschiedliche Shorehärten des Elastomers einsetzbar sind.

Die mehreren verschachtelt angeordneten Noppen (Erhebungen 7) an der Oberfläche der Elastomerhülle 6 erzeugen mehrere kleine Kontaktflächen zu der Innenfläche 26 des Kunststoffgehäuses 2. Durch die vereinzelten kleinen Kontaktflächen werden insbesondere folgende Vorteile erreicht: Die Kontaktfläche, wo Reibkräfte bei der Montage von dem bestückten PCB 3 in dem Kunststoffgehäuse 2 des Elektronikmoduls 1 entstehen, ist insgesamt reduziert und somit ist die Montagekraft, die für die Montage des PCB 3 aufzuwenden ist, kleiner. Dadurch kommen niedrigere Vorbelastungen / Spannungen an den Lötstellen des Elko's 4 und an den elektronischen Komponenten in unmittelbarer Umgebung des Elko's 4 an. Allgemein wird damit eine höhere Robustheit der Elko-Lötstellen über den Produktzyklus hinweg erreicht. Eine Entlüftung bei der Montage des PCB 3 im Kunststoffgehäuse 2 wird durch die verschachtelte Labyrinth-Geometrie der Noppen 7 erreicht. Der Elko 4 wird an mehreren Punkten abgestützt und gleichzeitig gedämpft bei Vibrationswirkungen auf das Elektronikmodul 1. Durch die prozessbedingte Entformschräge in der Form kann abhängig von dem vorhandenen Bauraum die Materialdicke des Elastomers im Topfbereich (im Bereich des Bodenabschnittes 5) der Elko 4 besonders klein werden. Um die Herstellbarkeit des Elastomerteils 6 zu verbessern, kann man lokale Materialaufdickungen (Verdickungsbereiche 17) in dem Topfbereich 15 des Teils am Umfang hinzufügen. Diese lokalen Aufdickungen 17 am Umfang erleichtern den Materialfluss im Spritzprozess. Neben der Herstellbarkeitsverbesserung erreicht man durch die lokalen Materialaufdickungen 17 auch eine bessere mechanische Stabilität des Teils. Unter Toleranzen werden die Lötstellen des Elko's 4 immer mit einem gewissen Anteil durch die Abstützung des Elko's 4 mit der Elastomerhülle 6 gegenüber der Gehäusewandung 2 belastet. Diese Belastung der Lötstellen kann durch eine passende Kombination von Elastizität des Materials (Härte / Shorehärte des Materials, Füllungen, Materialauswahl, etc.) und der Anzahl der Noppen 7 am Umfang auf die Außenfläche 23 reduziert werden. Gleichzeitig dazu kann eine gute Dämpfungsfunktion für den Elko 4 und der Vibrationen mit dem Elastomerteil garantiert werden.

### Bezugszeichenliste

- 1: Elektronikmodul
- 2: Gehäuse
- 3: Leiterplatte
- 4: elektronisches Bauteil / Elektrolytkondensator
- 5: Aufnahmeabschnitt
- 6: Dämpfungshülle / Elastomerhülle
- 7: Erhebung
- 8: Verbindungsbereich
- 9: Schlitz
- 10: Innenumfangsseite
- 11: Aushöhlung
- 12: Erhabenheit
- 13: erster Endbereich
- 14: zweiter Endbereich
- 15: Bodenabschnitt
- 16: Entlüftungsloch
- 17: Verdickungsbereich
- 18: erster Teilabschnitt
- 19: zweiter Teilabschnitt
- 20: Deckel
- 21: Aufnahmekörper
- 22: Außenseite
- 23: Außenumfangsseite
- 25: Einschiebeöffnung
- 26: Innenmantelseite
- 27: Längsachse
- 28: Halteklammer
- 29: Grundsockelabschnitt

## Patentansprüche

1. Elektronikmodul (1) für einen in einem Kraftfahrzeug verwendeten Aktor, mit einem Gehäuse (2) und einer in dem Gehäuse (2) aufgenommenen Leiterplatte (3), wobei ein elektronisches Bauteil (4), das mit der Leiterplatte (3) verbunden ist und in einem Aufnahmeabschnitt (5) des Gehäuses (2) angeordnet ist, zumindest abschnittsweise von außen von einer Dämpfungshülle (6) umgeben ist, die dämpfend auf eine Relativbewegung zwischen dem elektronischen Bauteil (4) und dem Aufnahmeabschnitt (5) einwirkt, wobei die Dämpfungshülle (6) hülsenförmig ausgestaltet ist **dadurch gekennzeichnet, dass** die Dämpfungshülle (6) mehrere voneinander beabstandete, abstehende Erhebungen (7) aufweist, die vorzugsweise an dem Aufnahmeabschnitt (5) anliegen.

2. Elektronikmodul (1) nach Anspruch 1, **dadurch gekennzeichnet, dass** die Dämpfungshülle (6) an dem elektronischen Bauteil (4) und dem Aufnahmeabschnitt (5) anliegt.

3. Elektronikmodul (1) nach Anspruch 1, **dadurch gekennzeichnet, dass** die Erhebungen (7) derart komprimiert gehalten sind, dass die Dämpfungshülle (6) in einem die Erhebungen (7) geometrisch voneinander abgrenzenden Talbereich (8), unter Ausbildung eines Entlüftungsspaltes, beabstandet zu dem Aufnahmeabschnitt (5) angeordnet ist.

4. Elektronikmodul (1) nach einem der Ansprüche 1 bis 3, **dadurch gekennzeichnet, dass** die Dämpfungshülle (6) aus einem Elastomermaterial hergestellt ist.

5. Elektronikmodul (1) nach einem der Ansprüche 1 bis 4, **dadurch gekennzeichnet, dass** das elektronische Bauteil (4) ein Kondensator, etwa ein Elektrolytkondensator, ist.

6. Elektronikmodul (1) nach einem der Ansprüche 1 bis 5, **dadurch gekennzeichnet, dass** die Dämpfungshülle (6) an einem Endbereich (13) einen Bodenabschnitt (15) ausbildet, der ein zentrales, durchgängiges Entlüftungsloch (16) aufweist.

7. Elektronikmodul (1) nach Anspruch 6, **dadurch gekennzeichnet, dass** die Dämpfungshülle (6) mehrere Verdickungsbereiche (17) aufweist, die sich (in axialer Richtung) bis zu dem Bodenabschnitt (15) hin erstrecken.

8. Elektronikmodul (1) nach einem der Ansprüche 1 bis 7, **dadurch gekennzeichnet, dass** die Dämpfungshülle (6) zumindest zwei Teilabschnitte (18, 19) aufweist, wovon ein erster Teilabschnitt (18) einen größeren Innendurchmesser aufweist als ein zweiter Teilabschnitt (19).

9. Aktor zum Betätigen einer Kupplung und/oder eines Getriebes eines Kraftfahrzeuges, mit einem Elektronikmodul (1) nach zumindest einem der Ansprüche 1 bis 8, das elektrisch mit einer Antriebseinheit des Aktors verbunden ist.

## Claims

1. An electronic module (1) for an actuator used in a motor vehicle, having a housing (2) and a printed circuit board (3) received in the housing (2), wherein an electronic component (4), which is connected to the printed circuit board (3) and arranged in a receiving section (5) of the housing (2), is at least partially surrounded from the outside by a damping sheath (6), which has a damping action on a relative movement between the electronic component (4) and the receiving section (5), wherein the damping sheath (6) is of sleeve-shaped design,
**characterised in that** the damping sheath (6) has a plurality of distanced, projecting elevations (7) which preferably rest against the receiving section (5).

2. The electronic module (1) according to claim 1, **characterised in that** the damping sheath (6) rests against the electronic component (4) and the receiving part (5).

3. The electronic module (1) according to claim 1, **characterised in that** the projections (7) are held compressed in such a way that the damping sheath (6) is arranged in a valley region (8) geometrically delimiting the projections (7) from one another, forming a venting gap at a distance from the receiving section (5).

4. The electronic module (1) according to any one of claims 1 to 3, **characterised in that** the damping sheath (6) is made of an elastomer material.

5. The electronic module (1) according to any one of claims 1 to 4, **characterised in that** the electronic component (4) is a capacitor, for example an electrolyte capacitor.

6. The electronic module (1) according to any one of claims 1 to 5, **characterised in that** the damping sheath (6) forms a bottom section (15) at an end region (13), which has a central, continuous venting hole (16).

7. The electronic module (1) according to claim 6, **characterised in that** the damping sheath (6) has a plurality of thickening regions (17) extending (in the axial direction) to the bottom section (15).

8. The electronic module (1) according to any one of claims 1 to 7, **characterised in that** the damping sheath (6) has at least two sub-sections (18, 19), of which a first sub-section (18) has a larger internal diameter than a second sub-section (19).

9. An actuator for actuating a clutch and/or a transmission of a motor vehicle, having an electronic module (1) according to at least one of claims 1 to 8, which is electrically connected to a drive unit of the actuator.

## Revendications

1. Module électronique (1) pour un actionneur utilisé dans un véhicule automobile, avec un boîtier (2) et une carte de circuit imprimé (3) logée dans le boîtier (2), un composant électronique (4) connecté à la carte de circuit imprimé (3) et disposé dans une section de réception (5) du boîtier (2), étant entouré au moins partiellement de l'extérieur par une gaine d'amortissement (6), qui a un effet d'amortissement sur un mouvement relatif entre le composant électronique (4) et la section de réception (5), la gaine d'amortissement (6) étant en forme de gaine, **caractérisé en ce que** la gaine d'amortissement (6) présente une pluralité d'élévations saillantes espacées (7) qui prennent de préférence appui contre la section de réception (5).

2. Module électronique (1) selon la revendication 1, **caractérisé en ce que** la gaine d'amortissement (6) prend appui contre le composant électronique (4) et la section de réception (5).

3. Module électronique (1) selon la revendication 1, **caractérisé en ce que** les élévations (7) sont maintenues comprimées de telle sorte que la gaine d'amortissement (6) est disposée à distance de la section de réception (5) dans une zone de vallée (8) délimitant géométriquement les élévations (7), avec formation d'une fente de ventilation.

4. Module électronique (1) selon l'une quelconque des revendications 1 à 3, **caractérisé en ce que** la gaine d'amortissement (6) est fabriquée à partir d'un matériau élastomère.

5. Module électronique (1) selon l'une quelconque des revendications 1 à 4, **caractérisé en ce que** le composant électronique (4) est un condensateur, tel qu'un condensateur électrolytique.

6. Module électronique (1) selon l'une quelconque des revendications 1 à 5, **caractérisé en ce que** la gaine d'amortissement (6) forme une section inférieure (15) au niveau d'une zone d'extrémité (13), laquelle section inférieure présente un trou de ventilation central continu (16).

7. Module électronique (1) selon la revendication 6, **caractérisé en ce que** la gaine d'amortissement (6) présente une pluralité de zones d'épaississement (17) qui s'étendent (dans le sens axial) jusqu'à la section inférieure (15).

8. Module électronique (1) selon l'une quelconque des revendications 1 à 7, **caractérisé en ce que** la gaine d'amortissement (6) présente au moins deux sections partielles (18, 19), dont une première section partielle (18) a un diamètre intérieur supérieur à celui d'une seconde section partielle (19).

9. Actionneur pour actionner un embrayage et/ou une transmission d'un véhicule automobile, avec un module électronique (1) selon au moins l'une quelconque des revendications 1 à 8, lequel est électriquement connecté à une unité d'entraînement de l'actionneur.
